# EUROPEAN PATENT APPLICATION

(11) **EP 1 843 208 A2**
(43) Date of publication of application: **10.10.2007**
(21) Application number: 07006657.6
(22) Date of filing: 30.03.2007
(51) Int. Cl.: G03F 7/42

(54) **Photoresist stripping apparatus, method of recycling photoresist stripper, and method of manufacturing thin film transistor array panel using the photoresist stripping apparatus**

(30) Priority: 05.04.2006 KR 20060031098
(71) Applicant: Samsung Electronics Co., Ltd., Suwon-si, Gyeonggi-Do (KR)
(72) Inventor: Park, Hong-sick, Suwon-si, Gyeonggi-do (KR); Kim, Bong-kyun, Nam-gu, Incheon (KR); Choung, Jong-hyun, Yeongtong-gu, Suwon-si, Gyeonggi-do (KR); Shin, Won-suk, Yongin-si, Gyeonggi-do (KR); Hong, Sun-Young, Saeongbuk-gu, Seoul (KR); Lee, Byeong-jin, Yongin-si, Gyeonggi-do (KR)
(74) Representative: Dr. Weitzel & Partner

(57) **Abstract**

Provided is a photoresist (PR) stripping apparatus that enables the recycling of a photoresist stripper and utilizes a continuous filtering action during a filter operation. The PR-stripping apparatus includes a PR stripping tank for receiving a substrate having a PR pattern is disposed and for stripping of the PR pattern, a PR stripper recovery pipe for recovering a PR stripper from the PR stripping tank two or more filter units for filtering the PR stripper returned by the PR striper recovery pipe, and a PR stripper supply pipe for supplying the filtered PR stripper to the PR stripping tank. The two or more filter units are connected in parallel to each other between the PR stripper recovery pipe and the PR stripper supply pipe.

## Description

### BACKGROUND OF THE INVENTION

### 1. Field of the Invention

The present invention relates to a photoresist stripping apparatus, and more particularly, to a photoresist stripping apparatus that enables the recycling of a photoresist stripper and a continuous filtering action even when a filter is replaced, a method of recycling a photoresist stripper and a method of manufacturing a thin film transistor array panel using the photoresist stripping apparatus.

### 2. Description of the Related Art

Semiconductor integrated circuits, semiconductor devices, and semiconductor apparatuses are becoming an increasingly indispensable tool in modem society and find widespread utility in a wide variety of industrial areas. In particular, with development of the information society, electronic display apparatuses have become important in various fields and various electronic display apparatuses have been improved to meet various demands of the information society.

One of the main types of conventional electronic display apparatuses is the cathode ray tube (CRT). However, since the CRT is heavy and has a large volume and uses a large amount of power, flat display apparatuses such as liquid crystal displays, organic electroluminescent (EL) displays, and plasma display panels are widely used in various fields as a substitute of the CRT.

A thin film transistor (TFT) array panel in which a TFT array is disposed on a substrate can be used as a panel of a liquid crystal display or an organic electroluminescent (EL) device. The TFT array panel includes various wire patterns including gate lines, and data lines. In order to finely form these wire patterns, masking processes using a photoresist (PR) pattern are used.

A mask process uses an expensive stripper solution to strip a residual PR pattern after etching. Foreign substances float in the stripper solution used for stripping the PR pattern. Thus, when the stripper solution is reused in a subsequent stripping process, wire patterns may be contaminated. Accordingly, stripper solutions are mostly rendered useless after being used once. Furthermore, if a PR stripper contains an environmental pollutant, the disposal of the PR stripper requires an expensive disposal apparatus, thereby increasing mask process costs.

In order to decrease mask process costs, attempts to recycle a PR stripper have been made. By way of one example, a method of removing foreign substances contained in a PR stripper solution involves the use of a filter. However, the use of an expensive filter incurs great process costs. Furthermore, when filter clogging occurs due to continued use of the same filter, a process must be suspended until the filter is replaced. This is an acute problem in a lift-off mask process because the PR stripper contains more foreign substances, thereby requiring more frequent replacement of filters and thus more frequent down times.

### SUMMARY OF THE INVENTION

The present invention provides a photoresist (PR) stripping apparatus that enables the recycling of a PR stripper, and a continuous filtering action even when a filter is replaced.

The present invention also provides a method of recycling a PR stripper using the PR-stripping apparatus.

The present invention also provides a method of manufacturing a thin film transistor array panel using the PR-stripping apparatus.

These and other advantages of the present invention will be described in or be apparent from the following description of the preferred embodiments.

According to an aspect of the present invention, there is provided a PR-stripping apparatus including a PR stripping tank in which a substrate having a PR pattern is disposed and stripping of the PR pattern is performed, a PR stripper recovery pipe for recovering a PR stripper from the PR stripping tank, two or more filter units for filtering the PR stripper returned by the PR striper recovery pipe, and a PR stripper supply pipe for supplying the filtered PR stripper to the PR stripping tank, wherein the two or more filter units are connected in parallel to each other between the PR stripper recovery pipe and the PR stripper supply pipe.

According to another aspect of the present invention, there is provided a method of recycling a PR stripper, the method including opening a first filter unit among two or more filter units connected in parallel to each other between a PR stripper recovery pipe and a PR stripper supply pipe, recovering a PR stripper which has been used in a PR stripping process through the PR stripper recovery pipe, supplying the recovered PR stripper to the first filter unit and filtering the recovered PR stripper in the first filter unit, and supplying the filtered PR stripper to the PR stripper supply pipe so that the filtered PR stripper is recycled, wherein when the pressure of the recovered PR stripper measured before the filtering is more than a predetermined pressure level or when the pressure of the filtered PR stripper measured after the filtering is less than a predetermined pressure level, the first filter unit is closed, a second filter unit among the two or more filter units is opened, the recovered PR stripper is filtered in the second filter unit, and the filtered PR stripper is supplied to the PR stripper supply pipe so that the filtered PR stripper is recycled.

According to still another aspect of the present invention, there is provided a method of manufacturing a thin film transistor array panel using a PR-stripping apparatus, the PR-stripping apparatus comprising: a PR stripping tank in which a substrate having a PR pattern is disposed and stripping of the PR pattern is performed, a PR stripper recovery pipe for recovering a PR stripper from the PR stripping tank, two or more filter units for filtering the PR stripper returned by the PR striper recovery pipe, and a PR stripper supply pipe for supplying the filtered PR stripper to the PR stripping tank, wherein the two or more filter units are connected in parallel to each other between the PR stripper recovery pipe and the PR stripper supply pipe.

### BRIEF DESCRIPTION OF THE DRAWINGS

The above and other features and advantages of the present invention will become more apparent in light of the following description of embodiments of the invention with reference to the attached drawings in which:
FIG. 1 is a structural, highly simplified view of a photoresist (PR) stripping apparatus according to an embodiment of the present invention;
FIG. 2 is a structural view illustrating a first filter unit and a second filter unit of a PR-stripping apparatus according to an embodiment of the present invention;
FIG. 3 is a perspective view of a first filter of the FIG. 2 embodiment;
FIG. 4 is a structural view illustrating a first filter unit and a second filter unit of a PR-stripping apparatus according to another embodiment of the present invention;
FIG. 5A is a structural view illustrating a first filter unit and a second filter unit of a PR-stripping apparatus according to another embodiment of the present invention;
FIGS. 5B and 5C are structural views illustrating modified embodiments of the first filter unit and the second filter unit of FIG. 5A;
FIG. 6 is a perspective view illustrating a PR stripping tank of a PR-stripping apparatus according to embodiment of the present invention;
FIG. 7 is a high simplified structural view illustrating a PR-stripping apparatus according to an embodiment of the present invention;
FIG. 8 is a flow diagram illustrating a method of recycling a PR stripper according to an embodiment of the present invention; and
FIGS. 9 through 17 are sequential cross-sectional views illustrating a method of manufacturing a thin film transistor array panel according to an embodiment of the present invention.

### DETAILED DESCRIPTION OF THE INVENTION

Advantages and features of the present invention and methods of accomplishing the same may be understood more readily by reference to the following detailed description of preferred embodiments and the accompanying drawings. The present invention may, however, be embodied in many different forms and should not be construed as being limited to only the embodiments set forth herein. Rather, these embodiments are provided so that this disclosure will be thorough and complete and will fully convey the concept of the invention to those skilled in the art, and the present invention will only be defined by the appended claims.

Spatially relative terms, such as "below", "beneath", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. In addition, in the drawings, the thickness of layers and regions are exaggerated for clarity.

A photoresist (PR) stripping apparatus according to the present invention is described below more fully with reference to the accompanying drawings, in which exemplary embodiments of the invention are shown.

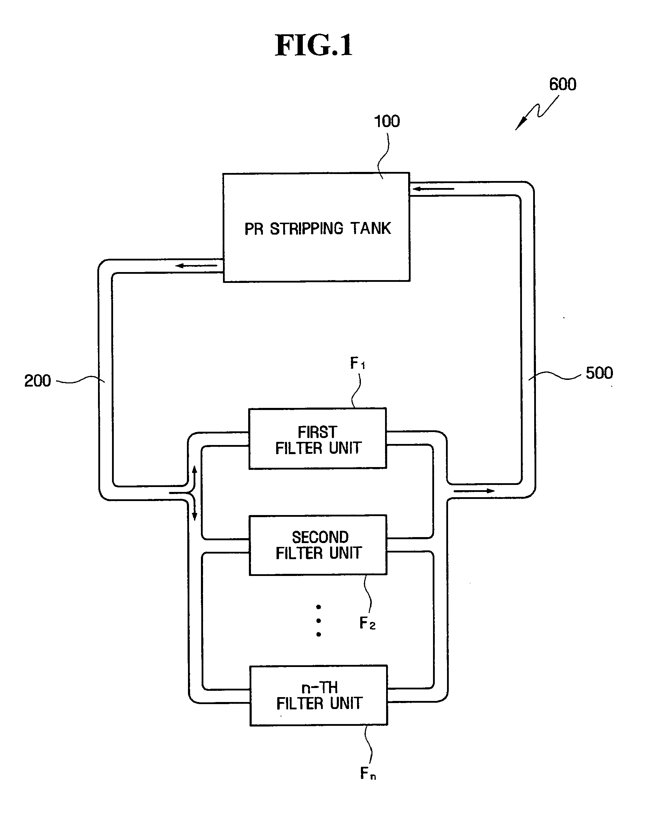

FIG. 1 is a structural view of a PR-stripping apparatus illustrating an embodiment of the present invention. In FIG. 1, the arrows represent the flow of a PR stripper. Referring to FIG. 1, a PR-stripping apparatus 600 includes a PR stripping tank 100, a PR stripper recovery pipe 200 for recovering a PR stripper from the PR stripping tank 100, a PR stripper supply pipe 500 for supplying filtered PR stripper to the PR stripping tank 100, and multiple filter units F1 to Fn connected in parallel to each other between the PR stripper recovery pipe 200 and the PR stripper supply pipe 500.

The bath (not shown) inside the PR stripping tank 100 includes therein a target substrate (not shown) on which a PR pattern is formed. Here, the target substrate may be a semiconductor substrate or an insulating substrate for a liquid crystal display, but the present invention is not limited to these examples. Further, the target substrates can be consecutively supplied singularly, or in units of cassettes where a plurality of substrates are mounted.

In the PR stripping tank 100, a stripping process of removing the PR pattern from the target substrate using a PR stripper is performed. In a preferred embodiment of the present invention, the PR stripper includes at least one of the following: an amine compound such as 2-(2-aminoethoxy)ethanol, 2-(2-aminoethylamino)ethanol, monoethane amine, diethylene triamine hydroxyamine, or alkanolamine; glycol ether such as diethylene glycol monomethyl ether, dipropylene glycol monomethyl ether, or tripropylene glycol monomethyl ether; and a polar solvent such as N-methyl-2-pyrrolidinone, tetrahydropropyl alcohol, isophorone, dimethylsulfoxide, dimethyladiphate, dimethylglutarate, sulforane, gamma-butyrolactone, or N,N-dimethylacetamice. In addition, the PR stripper may further include a surfactant such as ethoxylated alkyl phonol, 2-butyn-1,4-diol, or phosphoric acid ester. However, the composition of the PR stripper is not limited to the illustrated examples and various other mixtures may be used.

The PR stripper recovery pipe 200 is connected to the PR stripping tank 100. The PR stripper recovery pipe 200 extends to reach multiple filter units F1 to Fn, and is branched into multiple pipes near the filter units F1 to Fn. Two pipes connected to outlets of the filter units F1 to Fn meet at a junction and are connected to the PR stripper supply pipe 500.

A PR stripper that has been used in a PR stripping process in the PR stripping tank 100 is recovered through the PR stripper recovery pipe 200. Here, PR derived from the PR pattern removed during the PR stripping process is in a dissolved state or floats in the PR stripper returned through the PR stripper recovery pipe 200. The PR stripper returned through the PR stripper recovery pipe 200 may also contain a dissolved or floating form of a thin film forming material derived from a thin film formed on the target substrate during the PR stripping process and/or other foreign substances generated during the PR stripping process. The PR stripper containing the dissolved or floating form of PR and other foreign substances flows into one of the multiple filter units F1 to Fn via the PR stripper recovery pipe 200. The PR stripper flowing into the multiple filter units F1 to Fn is filtered through the multiple filter units F1 to Fn so that floating substances in the PR stripper, e.g., PR, a thin film forming material derived from a thin film formed on the target substrate, or other foreign substances are filtered out. The filtered PR stripper is recycled into the PR stripping tank 100 via the PR stripper supply pipe 500. Since no foreign substances are contained in the filtered PR stripper, the filtered PR stripper can be recycled for a subsequent PR stripping process without causing contamination problems.

Hereinafter, exemplary embodiments of the above-described PR-stripping apparatus will be described in more detail. In the description of the following embodiments, a description about constitutional elements having the same structure as those of the embodiment shown in FIG. 1 will be omitted or simplified. A construction that is not specifically described in one embodiment can be substituted by one of various combinations of constructions of the embodiment shown in FIG. 1 and the following other embodiments.

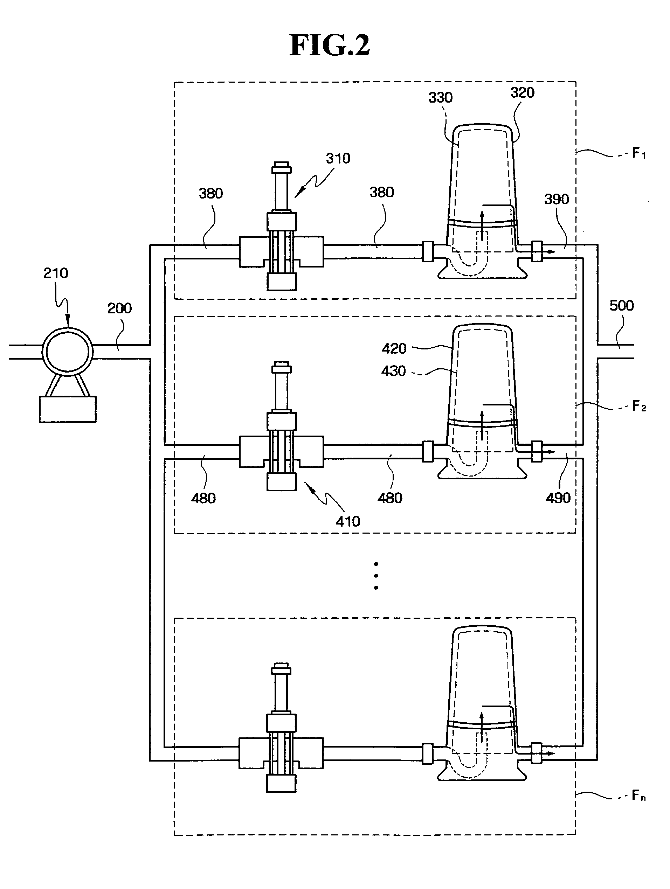

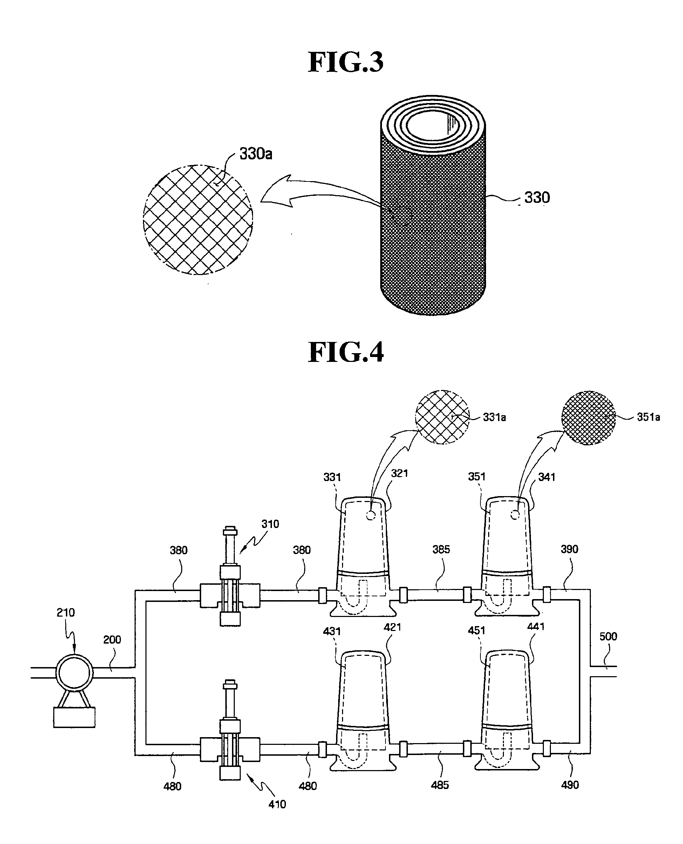

FIG. 2 is a structural view illustrating a first filter unit F1 and a second filter unit F2 of a PR-stripping apparatus according to an embodiment of the present invention, and FIG. 3 is a perspective view of a first filter 330 of FIG. 2.

Referring to FIGS. 2 and 3, the first filter unit F1 includes the first filter housing 320, the first filter 330 disposed in the first filter housing 320, a first PR stripper inlet pipe 380 connected between a PR stripper recovery pipe 200 and the first filter 330, and a first PR stripper outlet pipe 390 connected between the first filter 330 and a PR stripper supply pipe 500. The second filter unit F2 includes a second filter housing 420, a second filter 430 disposed in the second filter housing 420, a second PR stripper inlet pipe 480 connected between the PR stripper recovery pipe 200 and the second filter 430, and a second PR stripper outlet pipe 490 connected between the second filter 430 and the PR stripper supply pipe 500. As described above, the second filter unit F2 may have substantially the same structure as the first filter unit F1. Thus, unless specified otherwise, the following description about the first filter unit F1 can be also applied to the second filter unit F2.

The first filter housing 320 protects the first filter 330 and provides a space for receiving the first filter 330. For example, the first filter housing 320 may be made of a metal material. The first filter housing 320 has an empty space, and the first PR stripper inlet pipe 380 and the first PR stripper outlet pipe 390 are spatially connected to each other via the empty space of the first filter housing 320. Meanwhile, the first filter housing 320 can be structured such that its upper portion or other portion can be opened in order to easily replace the first filter 330 with a new one.

The first filter 330 serves to filter a PR stripper, and may be formed of a cylindrical metal mesh, as shown in FIG. 3. A laminate of two or more metal meshes may be used. The size of pores 330a of the metal mesh can be optionally determined according to the size of a target foreign substance. The metal mesh is made of a metal that can be easily washed physically or chemically after filtering out a foreign substance. For example, the metal mesh may be made of stainless steel. Thus, when the pores 330a of the first filter 330 are clogged with a foreign substance due to the repeated use of the first filter 330, the first filter 330 can be reused after being physically or chemically washed, thereby reducing process costs. The structure and material of the first filter 330 are not limited to the above-illustrated examples. The first filter 330 can be diversely structured using various materials.

Looking at FIG. 2, there is no structure shown which directs the fluid entering from pipe 380 to pass only through filter 330 before it exits through pipe 390. As shown, PR stripper leaving pipe 380 can go directly to pipe 390 without passing through filter 330.. Please provide drawings for both F1 and F2 to show the fluid routing in these units.

The first PR stripper inlet pipe 380, together with the second PR stripper inlet pipe 480 of the second filter unit F2, is connected to the PR stripper recovery pipe 200. A switching portion controlling the inflow of a PR stripper, e.g., a first switch valve 310 is installed at the first PR stripper inlet pipe 380. Similarly, a second switch valve 410 controlling the inflow of a PR stripper is installed at the second PR stripper inlet pipe 480.

When the first switch valve 310 installed at the first PR stripper inlet pipe 380 is opened, a PR stripper is supplied to the first filter 330 from the PR stripper recovery pipe 200 via the first PR stripper inlet pipe 380. When the second switch valve 410 installed at the second PR stripper inlet pipe 480 is opened, the PR stripper is supplied to the second filter 430 from the PR stripper recovery pipe 200 via the second PR stripper inlet pipe 480. A switchover operation of the first switch valve 310 and the second switch valve 410 can be optionally determined according to the cycle of recycling of a recovered PR stripper and/or an operating system. For example, in a case where there is a sufficient time to perform the filtering of a PR stripper, one of the first switch valve 310 and the second switch valve 410 may be opened and the other switch valve may be closed so that the PR stripper can be filtered through a filter corresponding to the opened switch valve. The filtered PR stripper is supplied to the PR stripper outlet pipe 500 via the first PR stripper outlet pipe 390 or the second PR stripper outlet pipe 490 as described above. At this time, in a filter unit corresponding to the closed switch valve, a used filter is separated from a filter housing and then replaced with a new one or washed. The new filter or the washed filter is reinstalled in the filter housing in order to be used for a subsequent filtering operation. That is, filter replacement or washing is performed without a suspension of a filtering operation, which improves process efficiency.

On the other hand, in a case where the filtering of a large amount of a PR stripper is required or a quick filtering of the PR stripper is required, both the first and second switch valves 310 and 410 may be opened so that the filtering of the PR stripper is simultaneously performed in the first and second filtering units F1 and F2. In this case, a filtered PR stripper is discharged into the first PR stripper outlet pipe 390 and the second PR stripper outlet pipe 490 and then collected into the PR stripper supply pipe 500. Although not shown, in a case where multiple filter units F1 to Fn are connected in parallel to each other between the PR stripper recovery pipe 200 and the PR stripper supply pipe 500, it will be easily understood by those of ordinary skill in the art that more various combinations can be made. That is, among the multiple filter units F1 to Fn, some grouped filter units can be opened, and the remaining filter units can be closed, and some of the closed filter units can be reopened, and some of the opened filter units can be re-closed. Likewise, the opening and closing of the multiple filter units F1 to Fn can be adjusted depending on factors such as the amount of PR stripper. In the following other embodiments, as a representative example of the various combinations, a case where at least one switch valve is opened and at least one of other switch valves is closed including two filter units will be illustrated.

Meanwhile, in order for a PR stripper to pass through the first filter 330 or the second filter 430, a predetermined pressure is required. For this, a PR-stripping apparatus according to present invention may include a pressurizing device. For example, the pressurizing device may be a pressurizing pump 210 disposed in line 200 or the first PR stripper inlet pipe 380.

In a detailed exemplary embodiment, the pressurizing pump may be disposed at one or more selected from the first PR stripper inlet pipe 380 between the first switch valve 310 and the first filter housing 320, the first PR stripper inlet pipe 380 between the first switch valve 310 and the PR stripper recovery pipe 200, and the PR stripper recovery pipe 200 in front of the first PR stripper inlet pipe 380 and the second PR stripper inlet pipe 480. In a case where a pressurizing pump is disposed at the first PR stripper inlet pipe 380 to pressurize a PR stripper toward the first filter 330, it is also necessary to provide the second PR stripper inlet pipe 480 with a pressurizing pump for pressurizing the PR stripper toward the second filter 430. That is, in this case, two or more pressurizing pumps are necessary. On the other hand, in a case where the pressurizing pump is disposed at the PR stripper recovery pipe 200, as shown in FIG. 2, a PR stripper flowing in the PR stripper recovery pipe 200 is pressurized and then supplied to the first filter 330 and/or the second filter 430. That is, in this case, filtering through the first filter unit F1 and/or the second filter unit F2 can be performed using only a single pressurizing pump.

As another example of the pressurizing device, there may be used a structural device achieving a gravitational potential energy difference by appropriately positioning the first and second PR stripper inlet pipes 380 and 480, the first and second PR stripper outlet pipes 390 and 490, and the first and second filters 330 and 430.

Hereinafter, a PR-stripping apparatus according to another embodiment of the present invention will be described with reference to FIG. 4. In the embodiment of the present invention shown in FIG. 4, a description about constitutional elements having the same structure as those of the previous embodiment of the present invention will be omitted or simplified.

FIG. 4 is a structural view illustrating a first filter unit and a second filter unit of a PR-stripping apparatus according to another embodiment of the present invention.

Referring to FIG. 4, a first filter unit includes two or more filters, e.g., a first front filter 331 and a first rear filter 351. The first front filter 331 is disposed in a first front filter housing 321, and the first rear filter 351 is disposed in a first rear filter housing 341. The first front filter 331 and the first rear filter 351 are serially connected to each other via a first PR stripper outlet/inlet pipe 385. The first front filter 331 is connected to a PR stripper recovery pipe 200 via a first PR stripper inlet pipe 380, and the first rear filter 351 is connected to a PR stripper supply pipe 500 via a first PR stripper outlet pipe 390. Similarly, a second filter unit of the current embodiment of the present invention includes two or more filters, e.g., a second front filter 431 and a second rear filter 451, which are serially connected to each other via a second PR stripper outlet/inlet pipe 485. The structure of the second filter unit is substantially the same as that of the first filter unit, and thus, only a description about the first filter unit will be provided hereinafter.

The first front filter 331 and the second rear filter 351 have substantially the same structure as the above-described first filter shown in FIG. 3. However, the size of pores 331a of the first front filter 331 may be different from the size of pores 351 a of the first rear filter 351. For example, as shown in FIG. 4, the size of the pores 351 a of the first rear filter 351 may be smaller than the size of the pores 331 a of the first front filter 331.

The filter units with the above-described structural characteristics achieve filtering of a PR stripper as follows. That is, a PR stripper flowed into the first front filter 331 via the first PR stripper inlet pipe 380 is primarily filtered through the first front filter 331. During the primary filtering, foreign substances having a larger size than the pores 331 a of the first front filter 331 are filtered out, whereas foreign substances having a smaller size than the pores 331a of the first front filter 331 pass through the first front filter 331. The primarily filtered PR stripper enters into the first rear filter 351 via the first PR stripper outlet/inlet pipe 385 and is then secondarily filtered through the first rear filter 351. At this time, smaller foreign substances can be filtered out since the size of the pores 351a of the first rear filter 351 is smaller than the size of the pores 331a of the first front filter 331. When filtering is performed twice as described above, foreign substances can be filtered out according to a particle size range, thereby increasing the filtering efficiency of the first front filter 331 and the first rear filter 351.

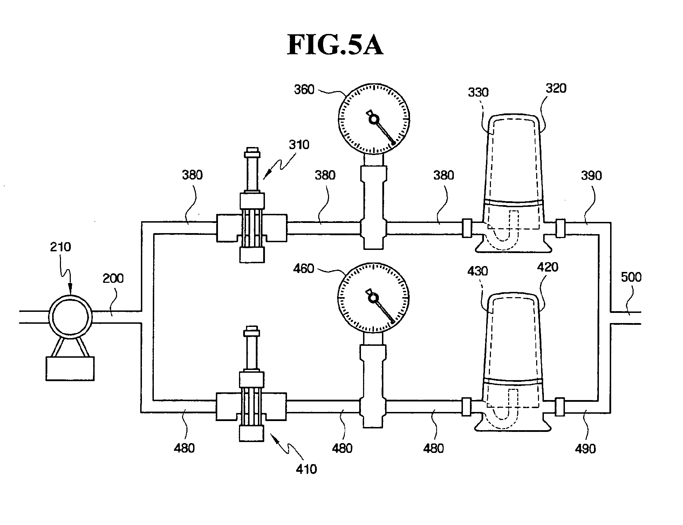

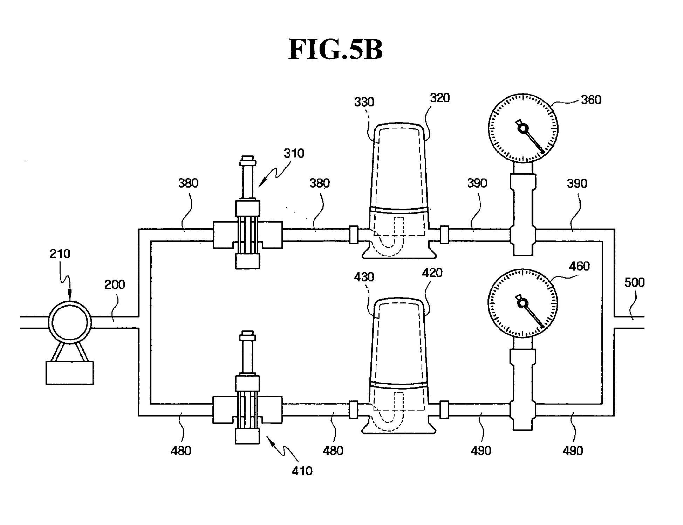

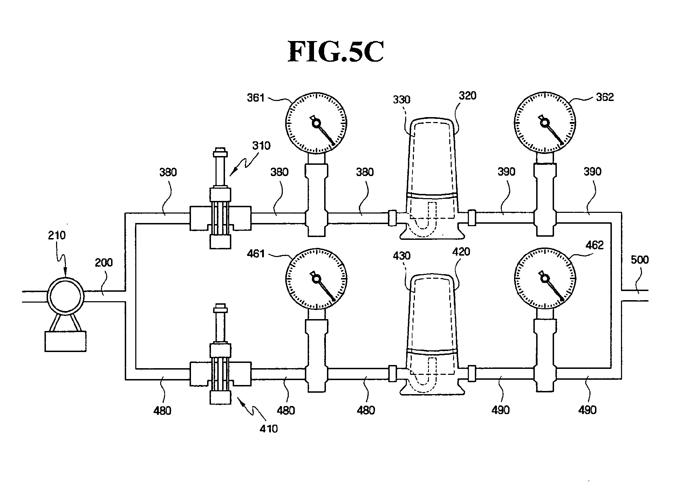

Hereinafter, a PR-stripping apparatus according to another embodiment of the present invention will be described with reference to FIGS. 5A through 5C. In the embodiment of the present invention shown in FIGS. 5A through 5C, a description about constitutional elements having the same structure as those of the previous embodiment of the present invention will be omitted or simplified. FIG. 5A is a structural view illustrating a first filter unit and a second filter unit of a PR-stripping apparatus according to still another embodiment of the present invention, and FIGS. 5B and 5C are structural views illustrating modified embodiments of the first filter unit and the second filter unit of FIG. 5A.

Referring to FIG. 5A, a PR-stripping apparatus includes first and second pressure gauges 360 and 460 for measuring the pressure of a PR stripper before the PR stripper passes through first and second filters 330 and 430, which is different from the PR-stripping apparatus of the embodiment shown in FIG. 2. For convenience of illustration, the current embodiment of the present invention will be described mainly with a view to a first filter unit. The first pressure gauge 360 is disposed at a first PR stripper inlet pipe 380 between a first filter housing 320 and a first switch valve 310 to measure the pressure of a PR stripper flowing toward the first filter housing 320.

For example, in a case where the first switch valve 310 is opened and filtering through the first filter 330 is repeatedly performed, foreign substances remained in the first filter 330 acts as a resistance against the flow of a PR stripper, thereby increasing the pressure of a PR stripper flowing toward the first filter 330. Thus, in a case where excess foreign substances are left in the first filter 330 and thus the first pressure gauge 360 senses more than a predetermined pressure level, filtering through the first filter 330 cannot be effectively performed. In this case, the first switch valve 310 is closed and a second switch valve 410 is opened so that filtering through the second filter 430 is performed. At this time, the first filter 330 is separated from the first filter housing 320 and then replaced with a new one or washed, and the new filter or the washed filter is reinstalled in the first filter housing 320. As described above, the detection of the pressure of a PR stripper flowing toward the first filter 330 by the first pressure gauge 360 ensures timely replacement of the first filter 330 with a new one.

Meanwhile, in addition to the pressure of a PR stripper in the first and second PR stripper inlet pipes 380 and 480, the pressure of a PR stripper in first and second PR stripper outlet pipes 390 and 490 is also changed according to the content of foreign substances in the first and second filters 330 and 430. With a view to the first filter unit, that is, in a case where excess foreign substances are left in the first filter 330, the flow rate of a PR stripper in the first PR stripper outlet pipe 390 is decreased, thereby decreasing the pressure of the PR stripper. In this regard, as shown in FIG. 5B, a first pressure gauge 360 may be installed at a first PR stripper outlet pipe 390. When measuring the pressure of a PR stripper using the first pressure gauge 360 installed at the first PR stripper outlet pipe 390, an appropriate time at which a first filter 330 can be replaced with a new one or washed can be determined. That is, when the first pressure gauge 360 senses less than a predetermined pressure level, the first filter 330 can be timely replaced with a new one or washed. Furthermore, in order to more accurately determine the time for filter replacement, as shown in FIG. 5C, a first front pressure gauge 361 may be installed at a first PR stripper inlet pipe 380 between a first switch valve 310 and a first filter housing 320, and a first rear pressure gauge 362 may be installed at a first PR stripper outlet pipe 490.

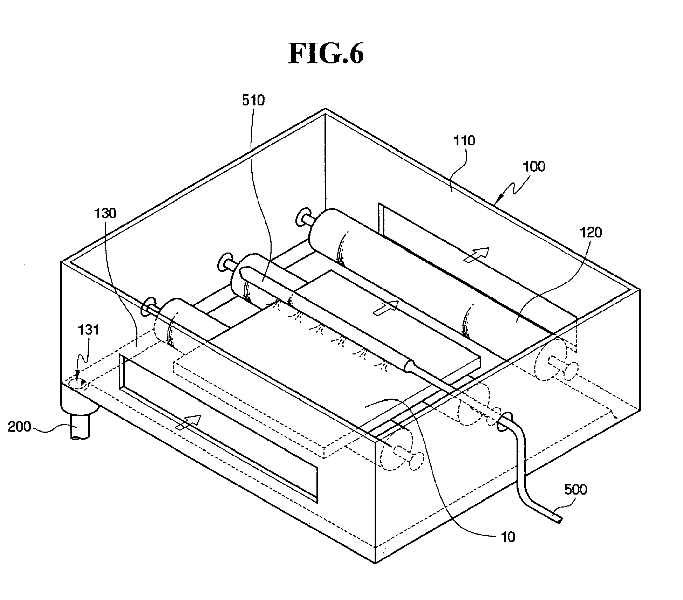

Hereinafter, a PR stripping tank of a PR-stripping apparatus according to another embodiment of the present invention will be described with reference to FIG. 6.

FIG. 6 is a perspective view illustrating a PR stripping tank 100 of a PR-stripping apparatus according to another embodiment of the present invention.

Referring to FIG. 6, the PR stripping tank 100 includes a PR stripping chamber 110, a plurality of transfer rollers 120 for moving a target substrate 10, a conduit 130 defined in a bottom of the PR stripping chamber 110, and a recovery hole 131 formed in a connection portion of a PR stripper recovery pipe 200.

The PR stripping chamber 110 may be in the form of a rectangular box. A spray nozzle 510 connected to an end of a PR stripper supply pipe 500 is disposed at an upper portion of the PR stripping chamber 110. The spray nozzle 510 may be fixedly installed at the upper portion of the PR stripping chamber 110, and uniformly downwardly sprays a PR stripper supplied from the PR stripper supply pipe 510.

The plurality of the transfer rollers 120 is installed at lower sidewalls of the PR stripping chamber 110. The target substrate 10, e.g., an insulating substrate for a liquid crystal display, is disposed on the transfer rollers 120. The target substrate 10 may be moved in one direction by the rotation of the transfer rollers 120, and thus, a PR stripper from the spray nozzle 510 may be uniformly sprayed onto an upper surface of the target substrate 10.

The conduit 130 is formed along a bottom edge of the PR stripping chamber 110 and slants downwardly from the bottom surface of the PR stripping chamber 110 toward the bottom edge. The conduit 130 also slants downwardly toward the recovery hole 131 so that a PR stripper can be easily recovered in the PR stripper recovery pipe 200.

That is, after a PR stripper sprayed onto the target substrate 10 from the spray nozzle 510 removes a PR pattern (not shown) formed on the target substrate 10, it is dispensed onto the bottom of the PR stripping chamber 110 and then collected in the conduit 130 along the slant of the bottom of the PR stripping chamber 110. The PR stripper collected in the conduit 130 flows toward the recovery hole 131 along the slant direction of the conduit 130 and is then recovered in the PR stripper recovery pipe 200. The other constitutional elements of the current embodiment of the present invention can refer to corresponding ones according to the embodiment shown in FIG. 1. Of course, the other constitutional elements of the current embodiment of the present invention can also refer to a combination of corresponding ones of the embodiments shown in FIGS. 2 through 5C.

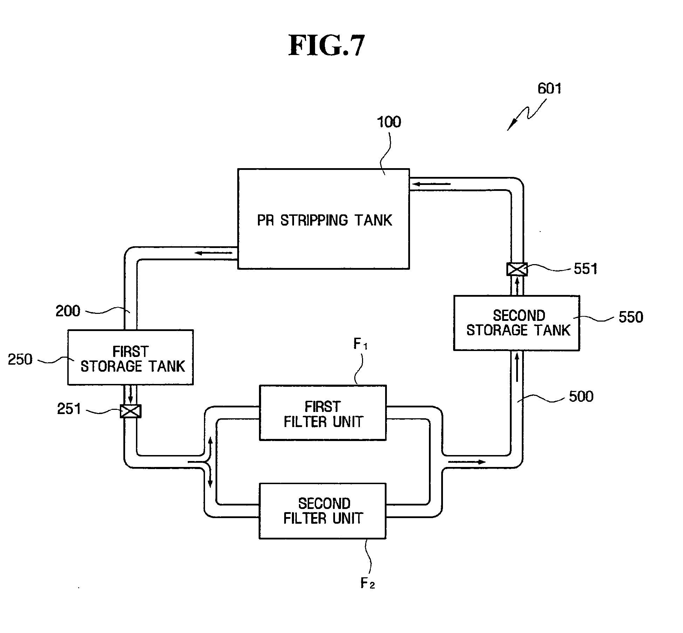

Hereinafter, a PR-stripping apparatus according to another embodiment of the present invention will be described with reference to FIG. 7.

FIG. 7 is a structural view illustrating a PR-stripping apparatus 601 according to another embodiment of the present invention.

Referring to FIG. 7, the PR-stripping apparatus 601 includes a first storage tank 250 connectedly installed at a PR stripper recovery pipe 200 and a second storage tank 550 connectedly installed at a PR stripper outlet pipe 500.

The first storage tank 250 stores a PR stripper returned from a PR stripping tank 100 at an appropriate level, and releases the PR stripper toward a first filter unit F1 and/or a second filter unit F2 when needed. For this, a switch valve 251 may be further installed at an outlet of the first storage tank 250. The second storage tank 550 stores a PR stripper that has been filtered through the first filter unit F1 and/or the second filter unit F2 and then supplies the PR stripper into the PR stripper supply pipe 500. When a PR stripping process is performed, the second storage tank 550 supplies the stored PR stripper to the PR stripping tank 100. For this, a switch valve 551 may be further installed at an outlet of the second storage tank 550. The amount of a PR stripper to be filtered and the amount of a PR stripper to be sprayed in the PR stripping tank 100 can be adjusted by the first and second storage tanks 250 and 550.

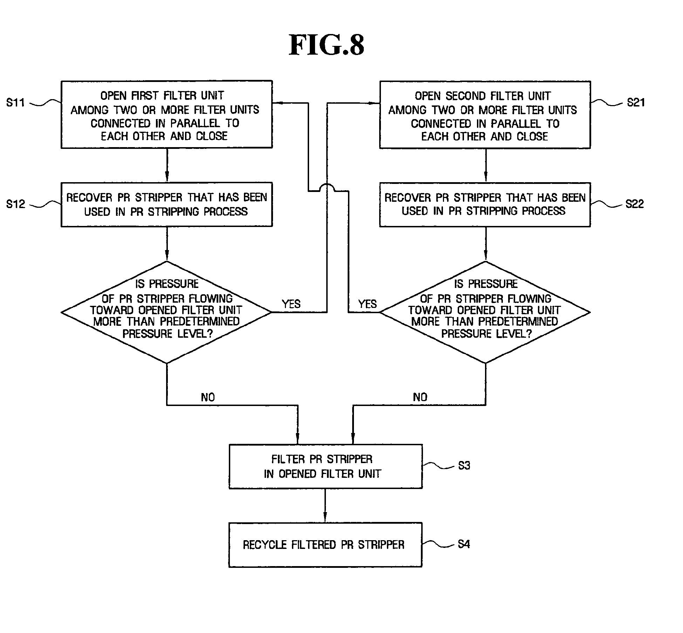

Hereinafter, a method of recycling a PR stripper using a PR-stripping apparatus according to the above-described embodiments of the present invention will be described with reference to FIG. 8 illustrating a flow diagram of a method of recycling a PR stripper using a PR-stripping apparatus as shown in FIGS. 1 through 7 according to an embodiment of the present invention.

Referring first to FIG. 8, at least one of two or more filter units connected in parallel to each other between a PR stripper recovery pipe and a PR stripper supply pipe, e.g., a first filter unit, is opened, and the other filter units, e.g., a second filter unit, are closed (S11). Here, the opening of the first filter unit and the closing of the other filter units can be achieved by a switchover operation of respective switch valves.

Then, a PR stripper that has been used in a PR stripping process is recovered (S12). The PR stripping process is performed in a PR stripping tank, and the PR stripper that has been used in the PR stripping process is recovered through the PR stripper recovery pipe connected to the PR stripping tank.

Then, the pressure of a PR stripper flowing toward the first filter unit is measured. The pressure of the PR stripper can be measured using a pressure gauge disposed in front of the first filter unit.

If the pressure of the PR stripper is less than a predetermined pressure level, the first filter unit is kept open to receive and filter the PR stripper (S3). The inflow of the PR stripper into the first filter unit can be achieved using a pressurizing device.

Then, the filtered PR stripper is recycled for a PR stripping process (S4). That is, the filtered PR stripper is sprayed in the PR stripping tank via a spray nozzle connected to the PR stripper supply pipe to perform a PR stripping process.

On the other hand, if the pressure of the PR stripper is more than a predetermined pressure level, the first filter unit is closed and a second filter unit among the two or more filter units is opened (S21).

Then, a PR stripper that has been used in a PR stripping process is recovered (S22).

Then, the pressure of a PR stripper flowing toward the second filter unit is measured. If the pressure of the PR stripper flowing toward the second filter unit is less than a predetermined pressure level, the PR stripper is allowed to flow into the second filter unit and then filtered in the second filter unit, and the filtered PR stripper is recycled for a PR stripping process (S3, S4). If the pressure of the PR stripper flowing toward the second filter unit is more than a predetermined pressure level, the processing routine is returned to operation S11 and the foregoing processes are repeated.

Meanwhile, when the pressure of a PR stripper is more than a predetermined pressure level, the first or second filter unit that has been closed may be replaced with a new filter. When filters of first and second filter units include a metal mesh, they may be reused after washing. Therefore, a PR stripper that has been used in a PR stripping process can be recycled with no rest time for filter replacement. Furthermore, the reuse of a filter can reduce process costs.

The embodiment shown in FIG. 8 has been illustrated with a view to measuring the pressure of a PR stripper before PR stripper supply to a filter, but the pressure of a PR stripper that has passed through a filter can also be measured. The measurement of the pressure of a PR stripper that has passed through a filter can be easily understood from the embodiments shown in FIGS. 5B, 5C, and 8, and thus, a description thereof will be omitted.

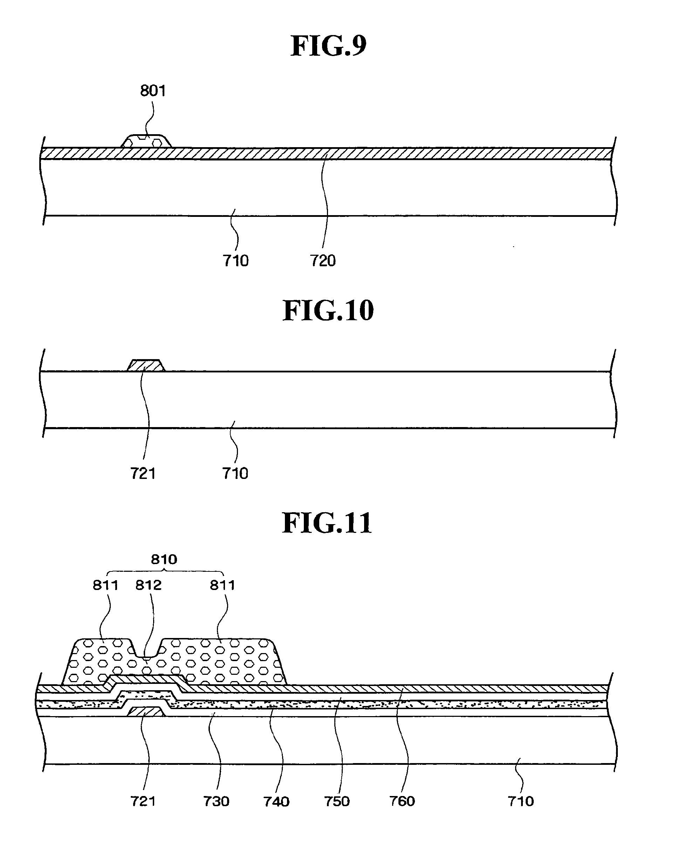

The above-described PR-stripping apparatuses can be used in a photolithographic process using PR. Hereinafter, a method of manufacturing a thin film transistor (TFT) array panel using a PR-stripping apparatus according to an embodiment of the present invention will be described with reference to FIGS. 9 through 17.

FIGS. 9 through 17 are sequential sectional views illustrating a method of manufacturing a thin film transistor array panel according to an embodiment of the present invention.

First, referring to FIG. 9, a conductive material is deposited on the entire surface of an insulating substrate 710 made of a transparent material, such as glass, using sputtering, etc. to form a gate conductive layer 720. Then, a PR film is coated on the gate conductive layer 720, exposed to light, and then developed to form a PR pattern 801.

Next, referring to FIG. 10, together with FIG. 9, the gate conductive layer 720 is wet-etched using the PR pattern 801 as an etching mask. Then, the PR pattern 801 is stripped. Here, a PR-stripping apparatus according to an embodiment of the present invention can be used. As a result, a gate electrode 721 is completed.

Next, referring to FIG. 11, together with FIG. 10, silicon nitride, hydrogenated amorphous silicon, and n+ hydrogenated amorphous silicon heavily doped with n-type impurity are consecutively deposited on the entire surface of the resultant structure of FIG. 10 using, e.g., chemical vapor deposition (CVD), to form a gate insulating layer 730, an intrinsic amorphous silicon layer 740, and a doped amorphous silicon layer 750. Then, a conductive material is deposited on the doped amorphous silicon layer 750 using sputtering, etc. to form a data conductive layer 760. Then, a PR film is coated on the data conductive layer 760, exposed to light, and developed to form a PR pattern 810. Here, the PR pattern 810 includes a channel PR pattern 812 overlapping the gate electrode 721, and a data PR pattern 811 which is connected to the channel PR pattern 812, is thicker than the channel PR pattern 812, and defines a source/drain electrode. The PR pattern 810 having differential thicknesses according to areas can be formed using a slit mask or a translucent film-containing mask.

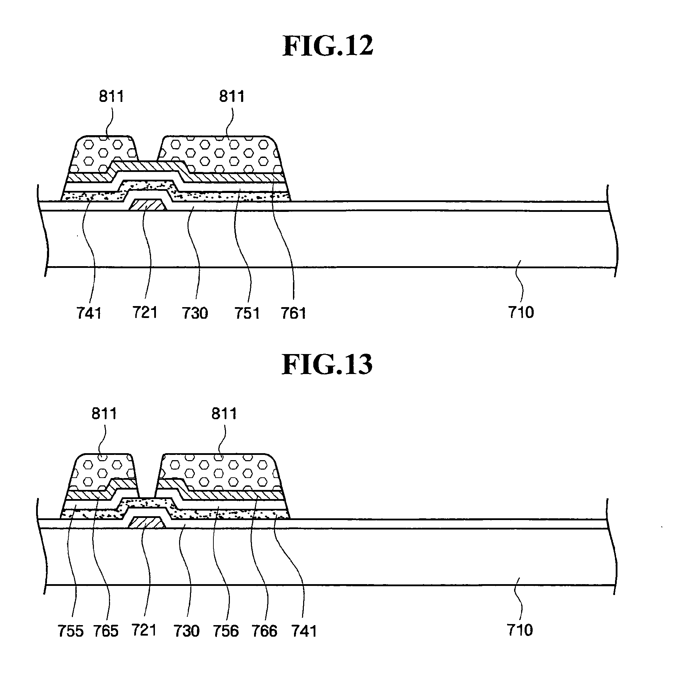

Next, referring to FIG. 12, together with FIG. 11, the data conductive layer 760 is wet-etched using the PR pattern 810 as an etching mask, and the doped amorphous silicon layer 750 and the intrinsic amorphous silicon layer 740 are then dry-etched. As a result, a semiconductor layer 741, a doped amorphous silicon layer pattern 751, and a data conductive layer pattern 761 are completed. Then, the resultant structure is etched-back to remove the channel PR pattern 812 of the PR pattern 810 and to expose the underlying data conductive layer pattern 761.

Next, referring to FIG. 13, together with FIG. 12, the exposed portion of the data conductive layer pattern 761 is wet-etched using the data PR pattern 811 as an etching mask, and the underlying doped amorphous silicon layer pattern 751 is then dry-etched.

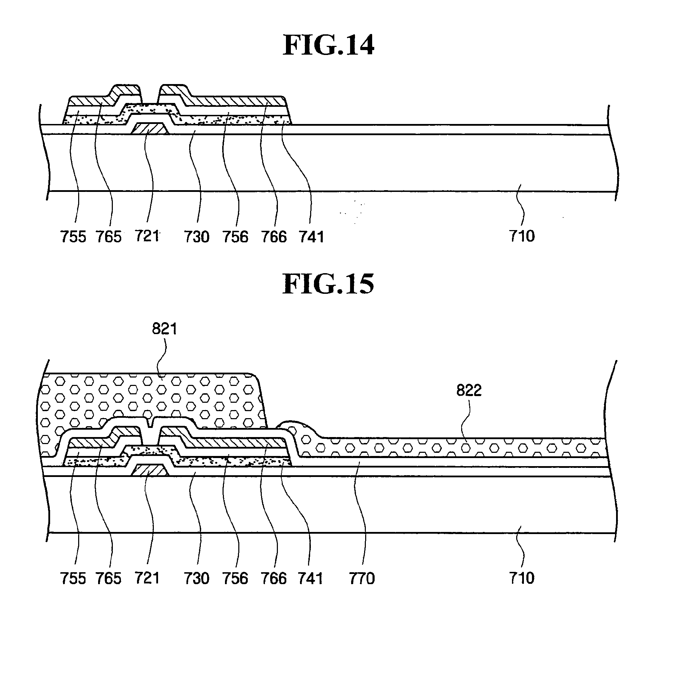

Next, referring to FIG. 14, together with FIG. 13, the data PR pattern 811 is stripped. Here, a PR-stripping apparatus according to an embodiment of the present invention can be used. As a result, a source electrode 765, a drain electrode 766, and the underlying ohmic contact layers 755 and 756 are completed.

Next, referring to FIG. 15, together with FIG. 14, silicon nitride is deposited on the resultant structure of FIG. 14 using, e.g., CVD, to form a passivation layer 770. Then, a PR film is coated on the passivation layer 770, exposed to light, and developed to form a first PR pattern 821 and a second PR pattern 822. At this time, the first PR pattern 821 disposed in a TFT region is thicker than the second PR pattern 822 disposed in a pixel electrode region. A portion of the drain electrode 766 is exposed through the first and second PR patterns 821 and 822. The first and second PR patterns 821 and 822 having different thicknesses can be formed using a slit mask or a translucent film-containing mask.

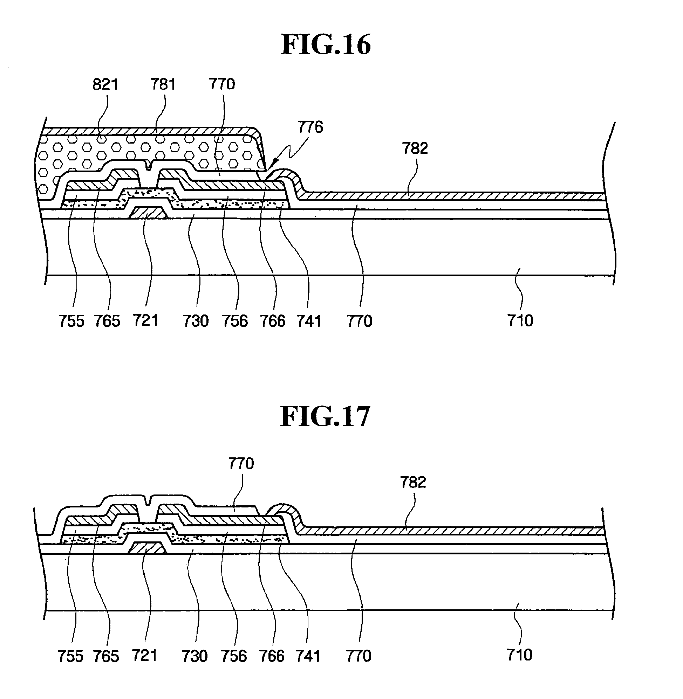

Next, referring to FIG. 16, together with FIG. 15, the passivation layer 770 is etched using the first and second PR patterns 821 and 822 as etching masks to form a contact hole 776 exposing the drain electrode 766. Then, the resultant structure is wholly etched-back to remove the second PR pattern 822.

Then, a transparent conductive material is deposited on the entire surface of the resultant structure using sputtering, etc.

Next, referring to FIG. 17, together with FIG. 16, a PR stripper is sprayed on the resultant structure of FIG. 16 to remove the first PR pattern 821 and to lift-off a transparent conductive oxide layer 781 on the first PR pattern 821. As a result, a TFT array panel as shown in FIG. 17 is completed. Here, a PR-stripping apparatus according to an embodiment of the present invention is used. At this time, PR derived from the removed first PR pattern 821 is dissolved or floats in the PR stripper, and a layer material derived from the lifted-off transparent conductive oxide layer 781 floats in the PR stripper. The foreign substances (i.e., the PR, the transparent conductive oxide layer material) in the PR stripper are recovered through a PR stripper recovery pipe of a PR-stripping apparatus and then filtered out in a filter unit as described above. The filtered PR stripper can be recycled for a subsequent stripping process. Furthermore, as described above, even when filter replacement is required due to repeated filtering, since two or more filters interconnected in parallel are used, continuous (i.e., alternate) filtering can be achieved. In addition, the use of a filter including a metal mesh ensures the reuse of the filter.

Therefore, a PR stripper containing foreign substances can be filtered through a filter and recycled, and even when the filter is changed due to repeated filtering, continuous filtering is possible, thereby improving process efficiency. Furthermore, since a used filter can be reused after being washed physically or chemically without replacing it with a new one, process costs can be reduced.

While the present invention has been particularly shown and described with reference to exemplary embodiments thereof, it will be understood by those of ordinary skill in the art that various changes in form and details may be made therein without departing from the spirit and scope of the present invention as defined by the following claims. It is therefore desired that the present embodiments be considered in all respects as illustrative and not restrictive, reference being made to the appended claims rather than the foregoing description to indicate the scope of the invention.

## Claims

1. A photoresist (PR) stripping apparatus comprising:
a PR stripping tank in which a substrate having a PR pattern is disposed and stripping of the PR pattern is performed;
a PR stripper recovery pipe connected to an output of the stripping tank for receiving a PR stripper from the PR stripping tank;
a plurality of filter units having inputs connected to the PR stripper recovery pipe and outputs, the plurality of filter units being adapted to filter the PR stripper received from the PR stripper recovery pipe; and
a PR stripper supply pipe connected to the outputs of the filter units for receiving filtered PR stripper and supplying the filtered PR stripper to an input of PR stripping tank,
wherein the plurality of filter units are connected in parallel.

2. The PR-stripping apparatus of claim 1, wherein at least one of the plurality of filter units comprises at least one filter which comprises a metal mesh.

3. The PR-stripping apparatus of claim 2, wherein the metal mesh is a stainless steel mesh, and the stainless steel mesh is comprised of a laminate of two or more stainless steel meshes.

4. The PR-stripping apparatus of claim 1, wherein the PR stripper returned by the PR stripper recovery pipe contains a floating material derived from a transparent conductive oxide layer.

5. The PR-stripping apparatus of claim 1, wherein each of the plurality of filter units further comprises a switch device for controlling a passage of the PR stripper.

6. The PR-stripping apparatus of claim 5, wherein at least one of the plurality of filter units comprises a first pressure gauge for measuring a pressure of the PR stripper before or after the PR stripper passes through the filter.

7. The PR-stripping apparatus of claim 1, further comprising a pressurizing device for pressurizing the PR stripper flowing toward the plurality of filter units.

8. The PR-stripping apparatus of claim 7, wherein the pressurizing device is a pressurizing pump, and the pressurizing pump is disposed at the PR stripper recovery pipe.

9. The PR-stripping apparatus of claim 1, wherein each of the plurality of filter units comprises two or more filters serially connected to each other.

10. The PR-stripping apparatus of claim 9, wherein the two or more filters have different pore sizes.

11. The PR-stripping apparatus of claim 1, further comprising:
a first storage tank which is connected to the PR stripper recovery pipe to store the recovered PR stripper and to supply the recovered PR stripper to the plurality of filter units; and
a second storage tank which is connected to the PR stripper supply pipe to store the filtered PR stripper passed through the two or more filter units and to supply the filtered PR stripper to the PR stripping tank.

12. The PR-stripping apparatus of claim 1, further comprising a spray nozzle positioned in the PR stripping tank, of the spray nozzle being connected to the PR stripper supply pipe and being adapted to spray filtered PR stripper on the substrate.

13. The PR-stripping apparatus of claim 12, wherein the PR stripping tank comprises at least one transfer roller for moving the substrate.

14. The PR-stripping apparatus of claim 1, wherein a base substrate of the substrate having the PR pattern is a transparent insulating substrate.

15. A method of recycling a PR stripper, the method comprising:
opening a first filter unit among two or more filter units connected in parallel to each other between a PR stripper recovery pipe and a PR stripper supply pipe;
recovering a PR stripper which has been used in a PR stripping process through the PR stripper recovery pipe;
supplying the recovered PR stripper to the first filter unit and filtering the recovered PR stripper in the first filter unit; and
supplying the filtered PR stripper to the PR stripper supply pipe so that the filtered PR stripper is recycled,
wherein when the pressure of the recovered PR stripper measured before the filtering unit is more than a first predetermined pressure level or when the pressure of the filtered PR stripper measured after the filtering is less than a second predetermined pressure level, operation of the first filter unit is ceased, and a second filter unit among the two or more filter units is used to filter the PR stripper received from the PR stripper recovery pipe.

16. The method of claim 15, wherein a filter of the first filter unit comprises a metal mesh, and
wherein after the first filter unit is closed, the filter of the first filter unit is separated from the first filter unit, washed, and then reinstalled in the first filter unit.

17. A method of manufacturing a thin film transistor array panel, the method comprising spraying a PR stripper on an insulating panel using the PR-stripping apparatus of claims 1 to 14, and recycling the PR stripper.
